# EUROPEAN PATENT APPLICATION

(11) **EP 4 318 053 A1**
(43) Date of publication of application: **07.02.2024**
(21) Application number: 22781479.5
(22) Date of filing: 23.03.2022
(51) Int. Cl.: G02B 3/14, G02B 26/00, C23C 16/34, C23C 16/50, C23C 16/44

(54) **VARIABLE FOCUS LIQUID LENS AND MANUFACTURING METHOD THEREFOR**

(30) Priority: 31.03.2021 KR 20210042189
(71) Applicant: Osong Medical Innovation Foundation, Cheongju-si, Chungcheongbuk-do 28160 (KR)
(72) Inventor: SEO, Seung Wan, Seoul 03373 (KR); YOO, Sung Keun, Sejong 30126 (KR)
(74) Representative: Lewis Silkin LLP
(86) International application number: PCT/KR2022/004087
(87) International publication number: WO 2022/211359

(57) **Abstract**

In a focus variable liquid lens and a method of manufacturing the focus variable liquid lens, the focus variable liquid lens includes a base substrate, an electrode par and a lens unit. The electrode part is formed on the base substrate, and has a central electrode and a plurality of electrodes. A printed circuit board is mounted to be electrically connected to the metal layer exposed to outside through the insulating layer. The lens unit has a liquid lens formed at the central electrode, and a light passes through the liquid lens. The liquid lens is located at a center of the central electrode and a focus of the light is located at an optical axis, when a voltage having the same magnitude is applied to the plurality of the electrodes. The liquid lens moves laterally from the central electrode and the focus of the light moves laterally from the center of the central electrode, when voltages of different magnitudes are applied to one of the plurality of the electrodes.

## Description

### BACKGROUND OF THE INVENTION

### TECHNICAL FIELD

Exemplary embodiments of the present invention relate to a focus variable liquid lens and a method of manufacturing the same. More particularly, exemplary embodiments of the present invention relate to a focus variable liquid lens and a method of manufacturing the same, applied to photoacoustic imaging technology and manufactured in a modular form to enable three-dimensional focus change.

### DISCUSSION OF THE RELATED ART

Recently, imaging technology using photoacoustic has the advantage of higher resolution compared to conventional ultrasound imaging technology, and various studies are being conducted as a next-generation medical device imaging technology.

In this imaging technology using photoacoustic, light energy is irradiated to biological tissue and the absorbed light energy induces thermal expansion at the cell level, and the sound wave signal caused by this thermal expansion is measured using an ultrasonic transducer.

To this end, the imaging technology using photoacoustic requires a light source for laser scanning, optical components such as a mirror scanner or auto stage and lens for irradiating the light source on the surface of the target sample, and a transducer for measuring ultrasonic signals.

In the case of scanning such a laser light source, in the conventional bench-top system, in addition to A scan along the optical axis of the light source using a galvanometer and an autostage to implement three-dimensional imaging, B scan or C scan which shifts the focus of the light source laterally is performed. In addition, in human implantable endoscopic probe system, when performing such B scan or C scan, radial signals are acquired through probe rotation for three-dimensional lateral imaging, and an additional external mechanical device for such probe rotation is essential.

Accordingly, the imaging technology using photoacoustic waves requires complicated optical setup and operation of the external mechanical device, and as a result, there are problems such as equipment complexity, size, and manufacturing cost.

The related prior art is Korean laid-open patent No. 10-2015-0035320.

### SUMMARY

Exemplary embodiments of the present invention provide to a focus variable liquid lens capable of constructing a simple optical system by omitting the mechanical drive device, and capable of being manufacturing in a modular form by miniaturizing the endoscope probe and performing three-dimensional focus variation.

Exemplary embodiments of the present invention also provide a method of manufacturing the focus variable liquid lens.

According to one aspect of the present invention, the focus variable liquid lens includes a base substrate, an electrode par and a lens unit. The electrode part is formed on the base substrate, and has a central electrode and a plurality of electrodes formed around the central electrode and insulated from each other. The lens unit has a liquid lens formed at the central electrode, and a light passes through the liquid lens. The liquid lens is located at a center of the central electrode and a focus of the light is located at an optical axis passing through the center of the central electrode, when a voltage having the same magnitude is applied to the plurality of the electrodes. The liquid lens moves laterally from the central electrode and the focus of the light moves laterally from the center of the central electrode, when voltages of different magnitudes are applied to one of the plurality of the electrodes.

In an exemplary embodiment, the plurality of the electrodes may include a first electrode located at a first side of the central electrode along a first direction, a second electrode located at a second side of the central electrode along the first direction, a third electrode located at a first side of the central electrode along a second direction perpendicular to the first direction, and a fourth electrode located at a second side of the central electrode along the second direction.

In an exemplary embodiment, the first to fourth electrodes may be arranged in a concentric direction around the central electrode, and may be insulated from the central electrode by an insulating part. Each of the first to fourth electrodes may have the same shape.

In an exemplary embodiment, each of the central electrode, the first electrode, the second electrode, the third electrode and the fourth electrode may receive a voltage independently.

According to another aspect of the present invention, in the method of manufacturing a focus variable liquid lens, a central electrode and an electrode part having a plurality of electrodes is formed to be spaced apart from each other on a base substrate. A metal layer is formed on each of the electrodes. An insulating layer to insulate the central electrode and the electrodes are formed from each other, and to expose the metal layer to outside. A liquid lens is mounted on the central electrode and an oil layer is formed to cover the liquid lens. An encapsulation layer is formed to encapsulate the oil layer.

In an exemplary embodiment, in forming the electrode part, the electrode part which is transparent may be deposited on the base substrate which is transparent, and then the electrode part may be patterned to form the central electrode and the plurality of the electrodes spaced apart from each other.

In an exemplary embodiment, in forming the metal layer, the metal layer having titanium (Ti) or gold (Au) may be formed in an area exposed to outside of the electrode part.

In an exemplary embodiment, in forming the insulating layer, silicon nitride (SiNx) may be deposited on the electrode part on which the metal layer is formed via plasma enhanced chemical vapor deposition (PECVD), and then the insulating layer may be formed by patterning the central electrode and the metal layer to be exposed to outside.

In an exemplary embodiment, after forming the insulating layer, a circuit board may be mounted to be electrically connected to the metal layer exposed to outside through the insulating layer. The encapsulation layer may be formed on an upper surface of the circuit board.

In an exemplary embodiment, the circuit board may be a flexible printed circuit board (FPCB).

In an exemplary embodiment, the encapsulation layer may be formed by depositing parylene polymer via chemical vapor deposition (CVD).

In an exemplary embodiment, before mounting the circuit board, a cover layer which is patterned to partially expose the metal layer and the insulating layer may be formed on the insulating layer.

In an exemplary embodiment, the oil layer may cover the liquid lens and may be formed on the partially exposed insulating layer.

In an exemplary embodiment, the liquid lens may have electrolyte and may be conductive. The liquid lens may be mounted on the central electrode with a spherical shape. The oil layer may have oil and is nonconductive. The oil layer may have a hemispherical shape.

According to exemplary embodiments of the present invention, a voltage is applied to each of a plurality of electrodes that is formed radially around the central electrode and is insulated from each other, and thus a position of the liquid lens located in the central lens is changed, so that a focus of the light passing through the liquid lens may be changed.

By applying the voltage of the same magnitude to the plurality of electrodes, the focus of light may be positioned at the optical axis, and by applying voltages of different magnitudes, the focus of light may be controlled to move laterally from the center of the central electrode. Therefore, the light with various directions and various focuses may be provided, and through this a three-dimensional focus variable lens may be constructed while omitting a mechanical drive device. Thus, a relatively simple optical system may be constructed and the endoscope probe may be miniaturized.

Here, since the direction and focus of light may be controlled by variously controlling the magnitude of the voltage applied to the plurality of electrodes, the ease of controlling or driving the liquid lens may be also improved.

In addition, in the manufacture of such liquid lenses, semiconductor manufacturing processes such as deposition and patterning may be applied as is, and thus the liquid lenses may be manufactured more easily and quickly.

In addition, since electrical connection with the flexible circuit board may be implemented through the exposed structure of the electrode through patterning, the liquid lens may be easily controlled or driven.

### BRIEF DESCRIPTION OF THE DRAWINGS

FIG. 1A is a perspective view illustrating a scan state along an optical axis of the light source in the focus variable liquid lens according to an example embodiment of the present invention, and FIG. 1B is a perspective view illustrating a scan state moving the focus of the light source laterally in the focus variable liquid lens of FIG. 1A;
FIG. 2A is a schematic view illustrating a plurality of electrodes of the focus variable liquid lens of FIG. 1A;
FIG. 3A, FIG. 3B, FIG. 3C, FIG. 3D, FIG. 3E, FIG. 3F and FIG. 3G are process views illustrating a method of manufacturing the focus variable liquid lens of FIG. 1A;
FIG. 4A is a schematic view illustrating a drive state for scanning of the light source along the optical axis, and FIG. 4B is a cross-sectional view illustrating a scan state as a result of the driving of FIG. 4A;
FIG. 5A is a schematic view illustrating a drive stat for scanning of the light source laterally, and FIG. 5B is a cross-sectional view illustrating a scan state as a result of the driving of FIG. 5A;
FIG. 6A, FIG. 6B, FIG. 6C and FIG. 6D are images respectively showing a side view of the light source, a plan view of the liquid lens, a plan view of the beam profile, and a perspective view of the beam profile, when the focus variable liquid lens of FIG. 1A is not driven;
FIG. 7A, FIG. 7B, FIG. 7C and FIG. 7D are images respectively showing a side view of the light source, a plan view of the liquid lens, a plan view of the beam profile, and a perspective view of the beam profile, when the focus variable liquid lens of FIG. 1A is scanning-driven along the optical axis; and
FIG. 8A, FIG. 8B, FIG. 8C and FIG. 8D are images respectively showing a side view of the light source, a plan view of the liquid lens, a plan view of the beam profile, and a perspective view of the beam profile, when the focus of the focus variable liquid lens of FIG. 1A is moved laterally.

**<reference numerals>**

| | | | |
|---|---|---|---|
| 10 : | focus variable liquid lens | 100 : | base substrate |
| 110 : | electrode part | 111 : | central electrode |
| 112 : | first electrode | 113 : | second electrode |
| 114 : | third electrode | 115 : | fourth electrode |
| 120 : | metal layer | 130 : | insulating layer |
| 140 : | cover layer | 150 : | circuit substrate |
| 200 : | lens unit | 210 : | lens part |
| 220 : | oil layer | 230 : | encapsulation layer |
| 401 : | insulating part | 402, 403, 404, 405 : | terminal |

### DETAILED DESCRIPTION OF THE INVENTION

The present invention is described more fully hereinafter with reference to the accompanying drawings, in which exemplary embodiments of the present invention are shown. The present invention may, however, be embodied in many different forms and should not be construed as limited to the exemplary embodiments set forth herein. Rather, these exemplary embodiments are provided so that this disclosure will be thorough and complete, and will fully convey the scope of the present invention to those skilled in the art.

The terminology used herein is for the purpose of describing particular exemplary embodiments only and is not intended to be limiting of the present invention. As used herein, the singular forms "a," "an" and "the" are intended to include the plural forms as well, unless the context clearly indicates otherwise.

It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, the present invention will be explained in detail with reference to the accompanying drawings.

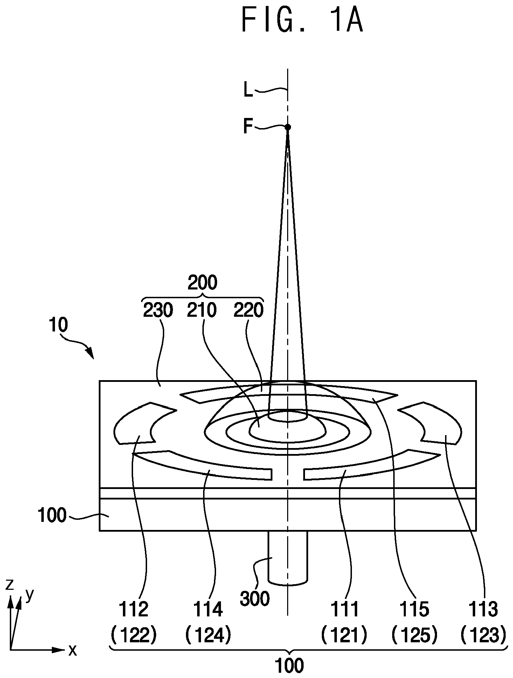

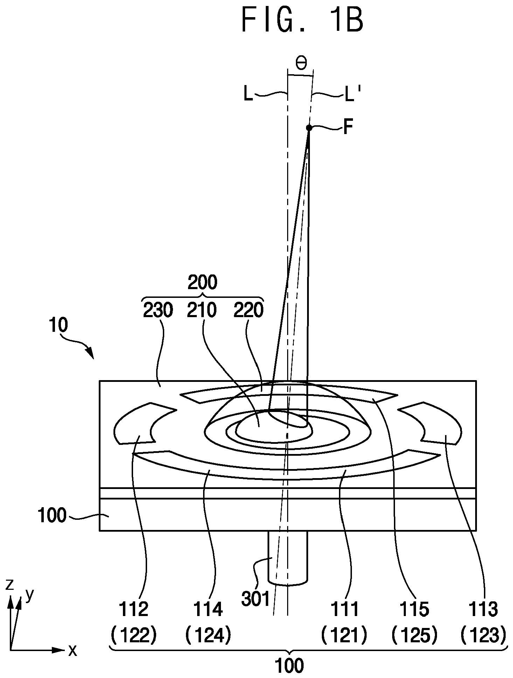

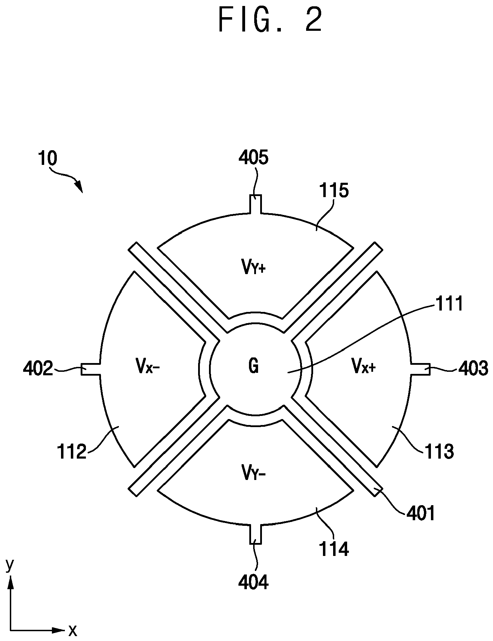

FIG. 1A is a perspective view illustrating a scan state along an optical axis of the light source in the focus variable liquid lens according to an example embodiment of the present invention, and FIG. 1B is a perspective view illustrating a scan state moving the focus of the light source laterally in the focus variable liquid lens of FIG. 1A. FIG. 2A is a schematic view illustrating a plurality of electrodes of the focus variable liquid lens of FIG. 1A.

Referring to FIG. 1A and FIG. 1B, the focus variable liquid lens 10 according to the present example embodiment includes a base substrate 100, an electrode part 110 and a lens unit 200.

The base substrate 100 may be a transparent substrate and have a plate shape with a predetermined area. The base substrate 100 may include glass or plastic, and may include various kinds of transparent material.

The electrode part 110 is formed on the base substrate 100, and includes a central electrode 111 formed at a center, and a plurality of electrodes 112, 113, 114 and 115 formed radially around the central electrode 111. In FIG. 1A and FIG. 1B, an electrode extended from the central electrode and exposed to outside is illustrated as the central electrode 111.

The central electrode 111 is formed on the center of the base substrate 100, and the lens unit 200 is mounted on the central electrode 111.

Here, an external voltage may be applied to the central electrode 111 if necessary, and thus the central electrode 111 may be exposed to outside. However, the lens unit 200 is mounted on the central electrode 111, and thus the central electrode 111 may not be directly exposed upwardly like other electrodes.

Thus, as illustrated in FIG. 1A and FIG. 1B, the central electrode 111 is extended toward an area adjacent to the exposed area of the third electrode 114 and then is exposed, and thus the central electrode 111 is illustrated to be disposed adjacent to the third electrode 114.

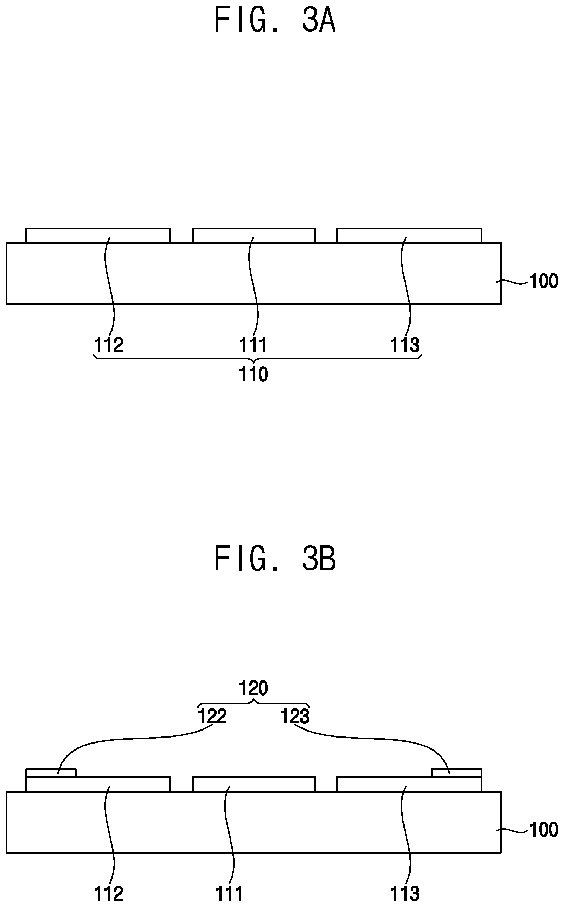

However, this merely shows that a terminal for exposing the central electrode 111 is exposed to the outside, and it is preferable to understand that the central electrode 111 is located at the center of the base substrate 100 on which the lens unit 200 is mounted, as shown in FIG. 2 and FIG. 3A.

In FIG. 1A and FIG. 1B, the central electrode 111 is illustrated to be exposed adjacent to the third electrode 114, but alternatively, the central electrode 111 may be extended to be exposed adjacent to one of the first electrode 112, the second electrode 113 and the fourth electrode 115.

In the present example embodiment, the plurality of electrodes 112, 113, 114 and 115 includes first to fourth electrodes. The first electrode 112 is formed at a first side of the central electrode 111 along a first direction X, the second electrode 113 is formed at a second side of the central electrode 111 along the first direction X, the third electrode 114 is formed at a first side of the central electrode 111 along a second direction Y, and the fourth electrode 115 is formed at a second side of the central electrode 111 along the second direction Y

Here, the first direction X is perpendicular to the second direction Y

In addition, the first to fourth electrodes 112, 113, 114 and 115 are arranged in a concentric or radial direction around the central electrode 111, and are formed left-right and up-down symmetrically with respect to the center of the central electrode 111.

In addition, the first to fourth electrodes 112, 113, 114 and 115 are insulated from each other and are spaced apart from each other, and likewise, the central electrode 111 is insulated from and spaced apart from the first to fourth electrodes 112, 113, 114 and 115.

The insulation between the central electrode 111 and the first to fourth electrodes 112, 113, 114 and 115 may be illustrated as in FIG. 2, and the insulating part 401 is formed between the electrodes.

In addition, as illustrated in FIG. 2, the first to fourth electrodes 112, 113, 114 and 115 are electrically connected to first to fourth terminals 402, 403, 404 and 405 respectively, and receive the voltages from outside. The voltages are provided to the first to fourth electrodes 112, 113, 114 and 115 independently.

Further, for the convenience of the explanation of the voltage supply, it is assumed that the first electrode 112 receives a first voltage Vx- through the first terminal 402, the second electrode 113 receives a second voltage Vx+ through the second terminal 403, the third electrode 114 receives a third voltage Vy- through the third terminal 404, and the fourth electrode 115 receives a fourth voltage Vy+ through the fourth terminal 405.

The lens unit 200 is mounted on the central electrode 111, and includes a liquid lens 210, an oil layer 220 and an encapsulation layer 230.

The liquid lens 210 includes an electrolyte-based conductive material with a predetermined volume, and the liquid lens 210 is mounted on the central electrode 111. The liquid lens 210 functions as a lens through which the laser light passes.

The liquid lens 210, for example, may have a spherical shape, and may be a lens forming a focus F in an upper portion as the laser light passes through, as illustrated in the figure.

The oil layer 220 covers the liquid lens 210, and for example, includes non-conductive oil. An outer surface of the oil layer 220 forms a partial surface of the spherical shape of the oil layer 220. Thus, the oil layer 220 covers the liquid lens 210 located at the central electrode 111, and the oil layer 220 is formed to have a hemispherical space inside of the oil layer 220 with an area larger than an area formed by the central electrode 111.

The encapsulation layer 230 covers the electrode part 110 and an outer surface of the oil layer 220, and forms an encapsulation to encapsulate the electrode 110, the oil layer 220 and the liquid lens 210. For example, the encapsulation layer 230 include parylene polymer and so on.

In the encapsulation layer 230, a pattern is formed to partially expose the electrode 110 to outside, and the partial portion of the electrode exposed to outside may be electrically connected to a flexible printed circuit board (FPCB), not shown in FIG. 1A and FIG. 1B.

A laser light 300 provided from outside passes through the liquid lens 210 and is focused, and here, the irradiation direction of the laser light 300 is changed according to the position of the liquid lens 210.

Referring to FIG. 1A, when the liquid lens 210 is located at a center of the central electrode 111, the laser light 300 passing through the liquid lens 210 has a focus F located along an optical axis L passing through the center of the central electrode 111.

When the voltage having the same magnitude is supplied to each of the first to fourth electrodes 112, 113, 114 and 115 disposed around the central electrode 111, the liquid lens 210 is located at the center of the central electrode 111, and thus, the focus F of the laser light 300 is located along the optical axis L.

However, referring to FIG. 1B, when the liquid lens 210 moves and is located along a direction from the central electrode 111, the laser light 300 passing through the liquid lens 210 has the focus F located along an axis L' tilted by a predetermined angle θ with respect to the optical axis L passing through the center of the central electrode 111.

When the voltages of different magnitudes are supplied to one of the first to fourth electrodes 112, 113, 114 and 115 disposed around the central electrode 111, the liquid lens 210 moves and is located along the direction from the central electrode 111, and thus, the focus F of the laser light 300 is located along the axis L' included by a predetermined angle θ with respect to the optical axis L.

Thus, the voltage applied to the first to fourth electrodes 112, 113, 114 and 115 disposed around the central electrode 111 is controlled, to change the positon of the liquid lens 210 variously. Then, the focus F of the laser light 300 may be located along the axis inclined by a predetermined angle with respect to the optical axis L.

Accordingly, by controlling the voltage applied to the electrodes, the light having various kinds of directions and focal lengths may be provided, and a three-dimensional focus variable lens may be implemented.

Hereinafter, the method of manufacturing the focus variable liquid lens 10 is explained in detail.

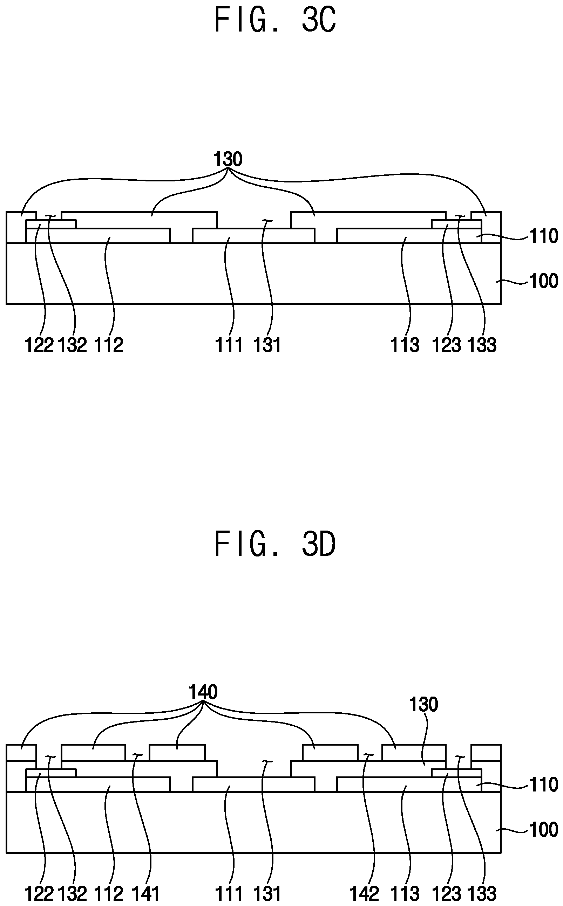

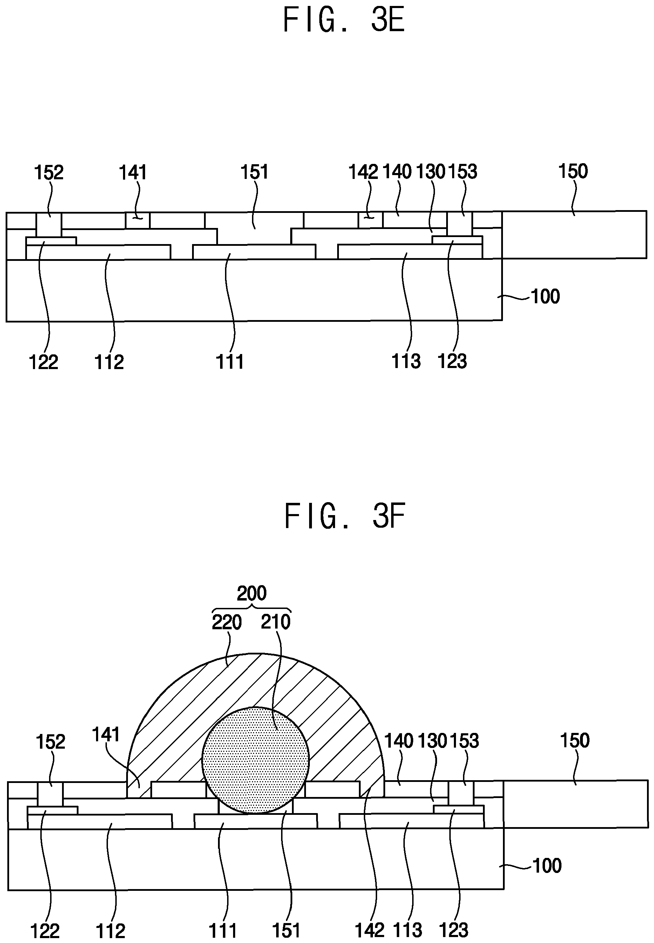

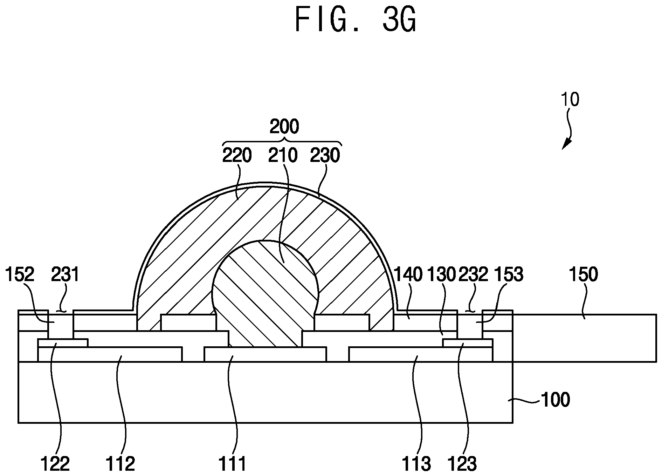

FIG. 3A, FIG. 3B, FIG. 3C, FIG. 3D, FIG. 3E, FIG. 3F and FIG. 3G are process views illustrating a method of manufacturing the focus variable liquid lens of FIG. 1A.

Referring to FIG. 3A, in the method of manufacturing the focus variable liquid lens 10, the electrode part 110 having the central electrode 111 and the plurality of electrodes 112 and 113 is formed on the base substrate 100.

First, since FIG. 3A, FIG. 3B, FIG. 3C, FIG. 3D, FIG. 3E, FIG. 3F and FIG. 3G are the cross-sectional views taken along the first direction X of FIG. 1A and FIG. 1B, in the figures, the arrangement and the forming of other electrodes may be in a range that can be derived by a person skilled in the art from the arrangement and the forming of the first and second electrodes 112 and 113, although the first and second electrodes 112 and 113 of the electrodes are merely illustrated.

In forming the electrode part 110, a transparent electrode is deposited on the base substrate 100, and then the transparent electrode is patterned using a mask by an etching process. Thus, the central electrode 111, and the first and second electrodes 112 and 113 disposed at both sides of the central electrode 111 are formed. Here, the first and second electrodes 112 and 113 are spaced apart from the central electrode 111 by a predetermined distance.

Here, the base substrate 100 may include transparent glass or plastic, and the electrode part 110 may also include a transparent electrode, such as an indium tin oxide (ITO) electrode.

Then, referring to FIG. 3B, a metal layer 120 having first and second metal layers 123 is formed. The first and second metal layers 122 and 123 are partially formed on the first and second electrodes 112 and 113, respectively.

Here, although not shown in the figure, before forming the metal layer 120, a photosensitizer is formed on the base substrate 100 on which the electrode part 110 is formed, and an area in which the circuit board 150 makes contact or an alignment mark is formed is removed among the area of the photosensitizer.

Then, the metal layer 120 may be deposited in the area in which the photosensitizer is removed, and thus the first metal layer 122 is partially formed on the first electrode 112 and the second metal layer 123 is partially formed on the second electrode 113.

Here, each of the first and second metal layers 122 and 123 may include a metal such as titanium (Ti), gold (Au) and so on.

Then, referring to FIG. 3C, the insulating layer 130 is formed on the base substrate 100 on which the metal layer 120 and the electrode part 110 are formed.

Here, the insulating layer 130 is deposited on the base substrate 100 on which the metal layer 120 and the electrode part 110 are formed, via plasma enhanced chemical vapor deposition (PECVD), and the insulating layer 130 is patterned via an etching process.

Thus, as illustrated in the figure, a central exposed portion 131 is formed over the central electrode 111. In addition, a first exposed portion 132 is formed over the first metal layer 122 and the first electrode 112, and a second exposed portion 133 is formed over the second metal layer 123 and the second electrode 113.

For example, the insulating layer 130 may include silicon nitride (SiNx), or may include silicon oxide (SiO₂), aluminum oxide (Al₂O₃), parylene polymer and so on.

The insulating layer 130 having silicon nitride or silicon oxide may be deposited via plasma enhanced chemical vapor deposition, the insulating layer 130 having aluminum oxide may be deposited via atomic layer deposition (ALD) or sputtering, and the insulating layer 130 having the parylene polymer may be deposited via chemical vapor deposition (CVD).

Then, referring to FIG. 3D, the cover layer 140 is formed on the base substrate 100 on which the insulating layer 130 is formed, and the cover layer 140 has a pattern partially exposing the metal layer 122 and 123 and the insulating layer 130 to outside.

In forming the cover layer 140, CYTOP, a family of super-hydrophobic fluoropolymers, is coated on the base substrate 100 on which the insulating layer 130 is formed, and then the CYTOP is patterned using a mask to form the cover layer 140.

Thus, as illustrated in the figure, the cover layer 140 exposes the first and second metal layers 122 and 123 to outside through the first exposed portion 132 and the second exposed portion 133, respectively. The cover layer 140 exposes the central electrode 111 to outside through the central exposed portion 131. The cover layer 140 exposes a portion of the insulating layer 130 formed on the first electrode 112 to outside through a first opening 141, and exposes a portion of the insulating layer 130 formed on the second electrode 113 to outside through a second opening 142.

Then, referring to FIG. 3E, the circuit board 150 is mounted on the base substrate 100 on which the electrode part 110, the metal layer 120, the insulating layer 130 and the cover layer 140 are formed.

Here, the circuit board 150 includes a first contact portion 152 electrically connected to the first metal layer 122 through the first exposed portion 132, a second contact portion 153 electrically connected to the second metal layer 123 through the second exposed portion 133, and a central contact portion 151 electrically connected to the central electrode 111 through the central exposed portion 131.

The circuit board 150 is electrically connected to the first metal layer 122 and the first electrode 112 through the first contact portion 152, and then the power is provided to the first electrode 112. The circuit board 150 is electrically connected to the second metal layer 123 and the second electrode 113 through the second contact portion 153, and then the power is provided to the second electrode 113. The circuit board 150 is electrically connected to the central electrode 111 through the central contact portion 151, and then the power is provided to the central electrode 111 or the central electrode 111 is grounded.

For example, the circuit board 150 may be a flexible printed circuit board (FPCB), and the first metal layer 122, the second metal layer 123 and the central electrode 111 are connected to the circuit board 150 via anisotropic conductive film (ACF) bonding.

The circuit board 150 is illustrated in FIG. 3E to be formed and connected over an entire of the base substrate 100, but, as illustrated in FIG. 1A and FIG. 1B, the circuit board 150 is enough to be electrically connected to the central metal layer 121 which is extended from the first metal layer 122, the second metal layer 123, the third metal layer 124, the fourth metal layer 125 and the central electrode 111 and is exposed to outside. Thus, the connecting position of the circuit board 150 may be variously formed.

For example, the circuit board 150 may be positioned not to make contact with the central electrode 111 or an area adjacent to the central electrode 111 in which the liquid lens 210 and the oil layer 220 are formed.

Then, referring to FIG. 3F, the liquid lens 210 is mounted on the central electrode 111 located at a center of the base substrate 100, and the oil layer 220 is formed to cover the liquid lens 210.

For example, the liquid lens 210 may have a spherical shape with a constant volume, and may be dispensed toward the central electrode 111. Here, the liquid lens 210 may include a material having electrolyte-based conductivity.

Accordingly, when the liquid lens 210 is disposed on the central electrode 111, as illustrated in FIG. 3G, the liquid lens 210 is mounted at the central exposed portion 131.

In addition, the oil part 220 is formed on and around the liquid lens 210, to cover the liquid lens 210.

For example, the oil layer 220 may have a predetermined thickness and cover the liquid lens 210. In addition, the oil layer 220 may be formed over an area in which the first and second opening portions 141 and 142 are formed to the surrounding area of the liquid lens 210.

Here, the oil layer 220 may have hemispherical shape entirely, considering the spherical shape of the liquid lens 210.

In addition, the oil layer 220 may include non-conductive material having oil, and thus the oil layer 220 insulates the liquid lens 210.

Then, the encapsulation layer 230 is formed on the base substrate 100 on which the liquid lens 210 and the oil layer 220 are formed, to encapsulate the oil layer 220 inside of the encapsulation layer 230.

The encapsulation layer 230 may be deposited on an outer surface of the oil layer 220 uniformly, and the encapsulation layer 230 may be deposited over an entire surface of the base substrate 100 to an area in which the oil layer 200 is not formed.

The encapsulation layer 230 may be formed by depositing parylene polymer using chemical vapor deposition.

Here, the first and second metal layers 122 and 123 are patterned to be exposed to outside and thus first and second external exposed portions 231 and 232 are formed through the encapsulation layer 230.

Here, as explained referring to FIG. 1A and FIG. 1B, since the third and fourth metal layers 124 and 125 and the central metal layer 121 should be exposed to outside in addition to the first and second metal layers 122 and 123, the encapsulation layer 230 should be patterned considering the above.

Accordingly, the liquid lens 210 and the oil layer 220 are stably disposed inside of the encapsulation layer 230, and the variable degree of the liquid lens 210 may be limited within a predetermined range.

Accordingly, the focus variable liquid lens 10 is manufactured.

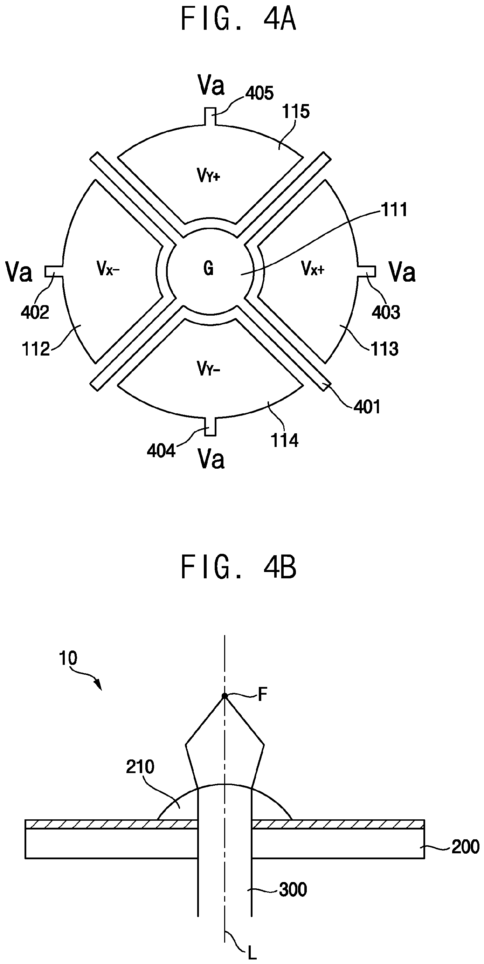

FIG. 4A is a schematic view illustrating a drive state for scanning of the light source along the optical axis, and FIG. 4B is a cross-sectional view illustrating a scan state as a result of the driving of FIG. 4A.

As explained in FIG. 2, in the focus variable liquid lens 10 according to the present example embodiment, the central electrode 111 and the first to fourth electrodes 112, 113, 114 and 115 are simply modeled, and based on the simple model, the drive of the focus variable liquid lens 10 is explained.

As illustrated in FIG. 4A, in driving the focus variable liquid lens 10, when the same voltage Va is applied to each of the first to fourth electrodes 112, 113, 114 and 115, the liquid lens 210 is located at the center of the central electrode 111.

Thus, the focus F of the laser light 300 irradiated to the liquid lens 210 is located along the optical axis L passing through the center of the central electrode 111.

Here, the liquid lens 210 does not change from its initial position, and the center of the liquid lens 210 is located at the center of the central electrode 111, and thus the focus F is located along the optical axis L.

When the magnitude of the voltage of the first to fourth electrodes 112, 113, 114 and 115 is changed (the voltage applied to each electrode is same and the magnitude of the voltage is merely changed), refractive index of the liquid lens 210 is changed, and thus the position of the focus L of the laser light 300 is changed along the optical axis L.

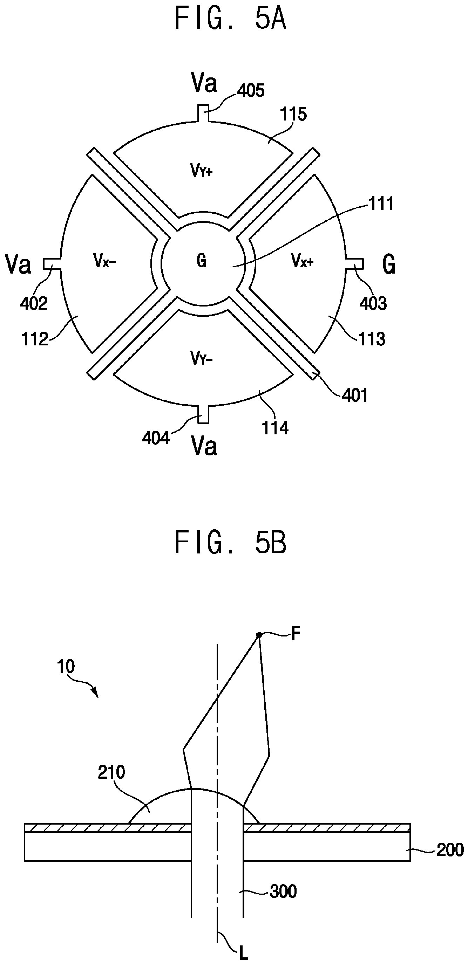

FIG. 5A is a schematic view illustrating a drive stat for scanning of the light source laterally, and FIG. 5B is a cross-sectional view illustrating a scan state as a result of the driving of FIG. 5A.

Alternatively, as illustrated in FIG. 5A, in driving the focus variable liquid lens 10, the same voltage Va is applied to each of the first electrode 112, the third electrode 114 and the fourth electrode 115, and the second electrode 113 is connected to the ground, as illustrated in FIG. 5B, the liquid lens 210 moves to a side from the center of the central electrode 111.

Here, the voltage Va is applied to the first electrode 112 and the second electrode 113 is connected to the ground, and thus the liquid lens 210 moves toward the first electrode 112 by a predetermined distance. In other words, the liquid lens 210 moves toward the electrode to which the relatively high voltage is applied.

Accordingly, when the liquid lens 210 moves toward the side of the center of the central electrode 111, the focus F of the laser light 300 irradiated to the liquid lens 210 is located at an axis which is moved to a side away from the optical axis L passing through the center of the central electrode 111.

For example, when the liquid lens 210 moves toward the first electrode 112 by a predetermined distance, the focus F of the laser light 300 may be located along the axis inclined toward the second electrode 113.

Accordingly, as the voltages applied to at least one of the first to fourth electrodes 112, 113, 114 and 115 are controlled to be different from each other, the focus F passing through the liquid lens 210 is located at the axis inclined with respect to the optical axis L by a predetermined angle.

Here, as explained above, when the voltage applied to the second electrode 113 is controlled to be relatively small, the focus F may be located along the axis inclined toward the second electrode 113. Thus, considering this, the position of the focus F may be variously controlled by controlling the voltage applied to each of the electrodes.

Further, the difference in the magnitude between the voltages applied to other electrodes and the voltage applied to the second electrode 113 is controlled variously, and thus, the inclined angle of the inclined axis along which the focus F is located may be variously controlled.

Accordingly, in the focus variable liquid lens 100 according to the present example embodiment, the voltages applied to the electrodes are variously controlled, and thus the focus of the light may be changed to various directions, and the liquid lens having the variable focus in the three-dimensional space may be implemented.

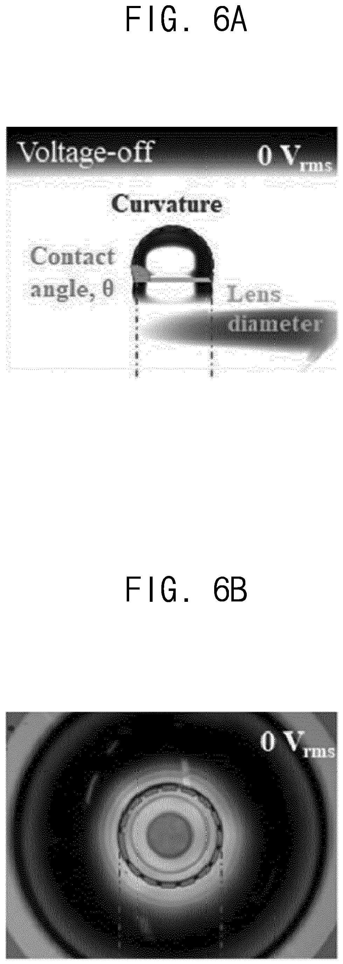

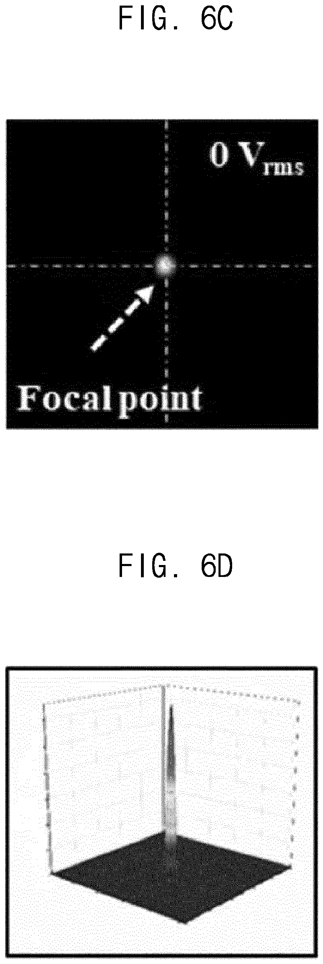

FIG. 6A, FIG. 6B, FIG. 6C and FIG. 6D are images respectively showing a side view of the light source, a plan view of the liquid lens, a plan view of the beam profile, and a perspective view of the beam profile, when the focus variable liquid lens of FIG. 1A is not driven.

Referring to FIG. 6A, FIG. 6B, FIG. 6C and FIG. 6D, in the focus variable liquid lens 10 according to the present example embodiment, in case that the voltage is not applied to each of the first to fourth electrodes 112, 113, 114 and 115, the laser light 300 passing through the liquid lens 210 passes through the center of the central electrode 111, and the focus of the laser light 300 is located along the optical light L.

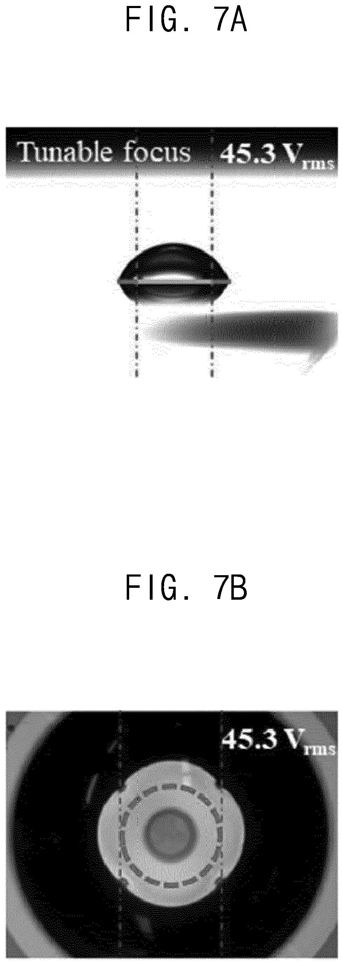

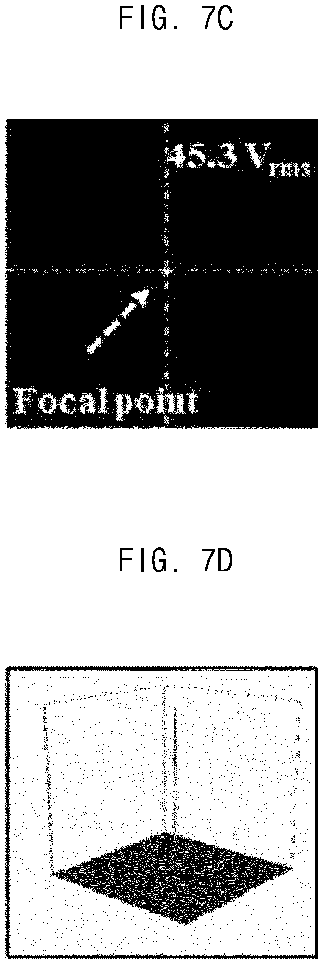

FIG. 7A, FIG. 7B, FIG. 7C and FIG. 7D are images respectively showing a side view of the light source, a plan view of the liquid lens, a plan view of the beam profile, and a perspective view of the beam profile, when the focus variable liquid lens of FIG. 1A is scanning-driven along the optical axis.

Likewise, referring to FIG. 7A, FIG. 7B, FIG. 7C and FIG. 7D, in the focus variable liquid lens 10 according to the present example embodiment, in case that the same voltage is applied to each of the first to fourth electrodes 112, 113, 114 and 115, the laser light 300 passing through the liquid lens 210 passes through the center of the central electrode 111, and the focus of the laser light 300 is located along the optical light L.

Here, when the same voltage is applied to each of the first to fourth electrodes, 112, 113, 114 and 115, the beam profile is formed to be different, compared to the case of the voltage not applied to the electrodes.

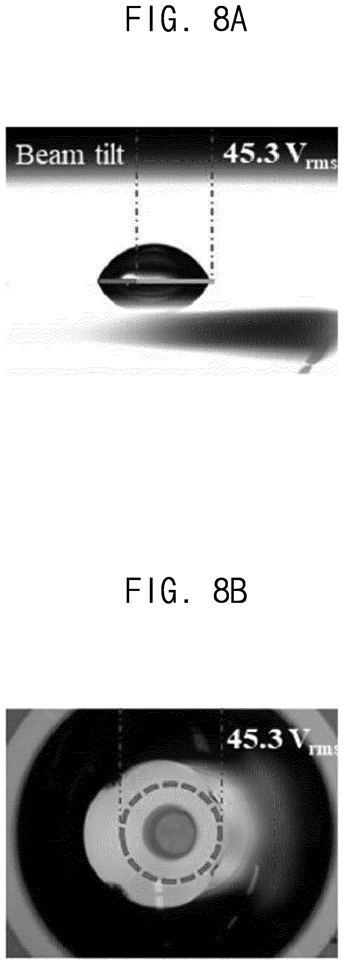

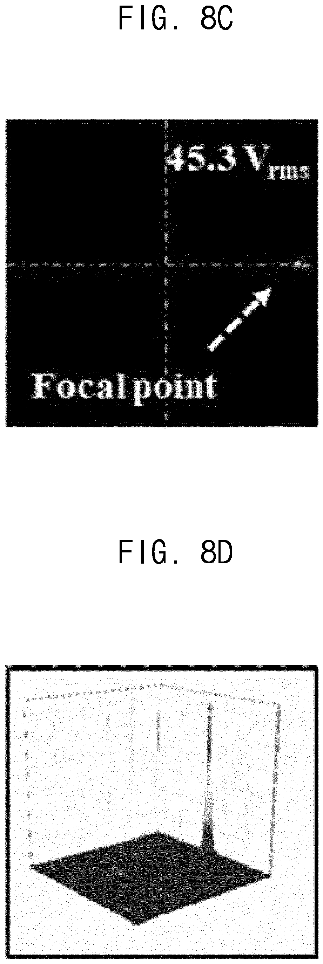

FIG. 8A, FIG. 8B, FIG. 8C and FIG. 8D are images respectively showing a side view of the light source, a plan view of the liquid lens, a plan view of the beam profile, and a perspective view of the beam profile, when the focus of the focus variable liquid lens of FIG. 1A is moved laterally.

Referring to FIG. 8A, FIG. 8B, FIG. 8C and FIG. 8D, in the focus variable liquid lens 10 according to the present example embodiment, in the case that the voltage having different magnitude is applied to only one of the first to fourth electrodes 112, 113, 114 and 115, the laser light 300 passing through the liquid lens 210 does not pass through the center of the central electrode 111, and the focus of the laser light 300 is located along the axis inclined with respect to the optical axis L by a predetermined angle.

Accordingly, as can be seen from the results of the experiments by applying an actual voltage to the focus variable liquid lens 10 manufactured through FIGS. 3A to 3G, the voltage applied to each of the electrodes of the focus variable liquid lens 10 is variously controlled, and thus, the position of the focus of the light passing through the focus variable liquid lens 10 may be variously controlled.

According to the present embodiment, a voltage is applied to each of a plurality of electrodes that is formed radially around the central electrode and is insulated from each other, and thus a position of the liquid lens located in the central lens is changed, so that a focus of the light passing through the liquid lens may be changed.

By applying the voltage of the same magnitude to the plurality of electrodes, the focus of light may be positioned at the optical axis, and by applying voltages of different magnitudes, the focus of light may be controlled to move laterally from the center of the central electrode. Therefore, the light with various directions and various focuses may be provided, and through this a three-dimensional focus variable lens may be constructed while omitting a mechanical drive device. Thus, a relatively simple optical system may be constructed and the endoscope probe may be miniaturized.

Here, since the direction and focus of light may be controlled by variously controlling the magnitude of the voltage applied to the plurality of electrodes, the ease of controlling or driving the liquid lens may be also improved.

In addition, in the manufacture of such liquid lenses, semiconductor manufacturing processes such as deposition and patterning may be applied as is, and thus the liquid lenses may be manufactured more easily and quickly.

In addition, since electrical connection with the flexible circuit board may be implemented through the exposed structure of the electrode through patterning, the liquid lens may be easily controlled or driven.

Having described exemplary embodiments of the present invention, it is further noted that it is readily apparent to those of reasonable skill in the art that various modifications may be made without departing from the spirit and scope of the invention which is defined by the metes and bounds of the appended claims.

## Claims

1. A focus variable liquid lens comprising:
a base substrate;
an electrode part formed on the base substrate, and having a central electrode and a plurality of electrodes formed around the central electrode and insulated from each other; and
a lens unit having a liquid lens formed at the central electrode, a light passing through the liquid lens,
wherein the liquid lens is located at a center of the central electrode and a focus of the light is located at an optical axis passing through the center of the central electrode, when a voltage having the same magnitude is applied to the plurality of the electrodes,
wherein the liquid lens moves laterally from the central electrode and the focus of the light moves laterally from the center of the central electrode, when voltages of different magnitudes are applied to one of the plurality of the electrodes.

2. The focus variable liquid lens of claim 1, wherein the plurality of the electrodes comprises:
a first electrode located at a first side of the central electrode along a first direction;
a second electrode located at a second side of the central electrode along the first direction;
a third electrode located at a first side of the central electrode along a second direction perpendicular to the first direction; and
a fourth electrode located at a second side of the central electrode along the second direction.

3. The focus variable liquid lens of claim 2, wherein the first to fourth electrodes are arranged in a concentric direction around the central electrode, and are insulated from the central electrode by an insulating part.
wherein each of the first to fourth electrodes has the same shape.

4. The focus variable liquid lens of claim 3, wherein each of the central electrode, the first electrode, the second electrode, the third electrode and the fourth electrode receives a voltage independently.

5. A method of manufacturing a focus variable liquid lens, the method comprising:
forming a central electrode and an electrode part having a plurality of electrodes to be spaced apart from each other on a base substrate;
forming a metal layer on each of the electrodes;
forming an insulating layer to insulate the central electrode and the electrodes from each other, and to expose the metal layer to outside;
mounting a liquid lens on the central electrode and forming an oil layer to cover the liquid lens; and
forming an encapsulation layer to encapsulate the oil layer.

6. The method of claim 5, wherein in forming the electrode part,
the electrode part which is transparent is deposited on the base substrate which is transparent, and then the electrode part is patterned to form the central electrode and the plurality of the electrodes spaced apart from each other.

7. The method of claim 5, wherein in forming the metal layer,
the metal layer having titanium (Ti) or gold (Au) is formed in an area exposed to outside of the electrode part.

8. The method of claim 5, wherein in forming the insulating layer,
silicon nitride (SiNx) is deposited on the electrode part on which the metal layer is formed via plasma enhanced chemical vapor deposition (PECVD), and then the insulating layer is formed by patterning the central electrode and the metal layer to be exposed to outside.

9. The method of claim 5, wherein after forming the insulating layer,
a circuit board is mounted to be electrically connected to the metal layer exposed to outside through the insulating layer, and
the encapsulation layer is formed on an upper surface of the circuit board.

10. The method of claim 9, wherein the circuit board is a flexible printed circuit board (FPCB).

11. The method of claim 9, wherein the encapsulation layer is formed by depositing parylene polymer via chemical vapor deposition (CVD).

12. The method of claim 9, wherein before mounting the circuit board,
a cover layer which is patterned to partially expose the metal layer and the insulating layer is formed on the insulating layer.

13. The method of claim 12, wherein the oil layer covers the liquid lens and is formed on the partially exposed insulating layer.

14. The method of claim 5, wherein the liquid lens has electrolyte and is conductive,
wherein the liquid lens is mounted on the central electrode with a spherical shape,
wherein the oil layer has oil and is nonconductive,
wherein the oil layer has a hemispherical shape.
